# FASCICULE DE BREVET EUROPEEN

(11) **EP 4 162 238 B1**
(45) Date de publication et mention de la délivrance du brevet: **27.09.2023**
(21) Numéro de dépôt: 22741344.0
(22) Date de dépôt: 15.06.2022
(51) Int. Cl.: G01G 19/44

(54) **DISPOSITIF DE MESURE ÉLECTRONIQUE AVEC ÉLECTRODE**
ELEKTRONISCHES MESSGERÄT MIT ELEKTRODE
ELECTRONIC MEASURMENT DEVICE WITH ELECTRODE

(30) Priorité: 22.06.2021 FR 2106653
(43) Date de publication de la demande: 12.04.2023
(73) Titulaire: Withings, 92130 Issy-les-Moulineaux (FR)
(72) Inventeur: CALLENS, Victorine, 92130 ISSY LES MOULINEAUX (FR); MENANTEAU, Matthieu, 92130 ISSY LES MOULINEAUX (FR); DONNET, Pierre-Arnaud, 92130 ISSY LES MOULINEAUX (FR); YUEN, Hok Wai, 92130 ISSY LES MOULINEAUX (FR)
(74) Mandataire: Withings IP
(86) Numéro de dépôt international: PCT/FR2022/051147
(87) Numéro de publication internationale: WO 2022/269166

(56) Documents cités:
- WO-A1-2017/079794
- FR-A1- 2 875 599

## Description

### Domaine technique

La présente divulgation relève du domaine des dispositifs de mesure électroniques et en particulier des pèse-personnes électroniques. La présente divulgation vise plus précisément un dispositif de mesure électronique permettant de mesurer un poids (ou une masse), une impédance corporelle, un électrocardiogramme (ECG), une pléthysmographie d'impédance (IPG), un ballistocardiogramme (BCG) et/ou de détecter des neuropathies. La présente divulgation se rapporte également à un procédé de fabrication d'un tel dispositif de mesure électronique.

### Technique antérieure

Un pèse-personne électronique, également appelé balance électronique, comprend couramment une plaque de pesage, sur laquelle se place un utilisateur, et un socle, définissant un volume interne recevant des circuits électroniques pour déterminer des mesures biométriques de l'utilisateur. La plaque de pesage peut être équipée d'électrodes destinées à venir au contact de l'utilisateur. Les électrodes peuvent par exemple permettre d'effectuer des mesures d'impédance (analyse de bio-impédance, BIA, ou analyse de pléthysmographie d'impédance, IPG), d'électrocardiogrammes (ECG) et/ou de détecter des neuropathies.

Dans le cas où le pèse-personne comprend de telles électrodes, il existe un besoin de relier électroniquement les électrodes aux circuits électroniques reçus à l'intérieur du pèse-personne.

Certains pèse-personnes prévoient des trous dans la plaque de pesage et d'y souder des fils conducteurs pour rejoindre les électrodes, comme brièvement décrit dans le document US9943241, ou dans la balance commercialisée par Withings^{™} sous le nom de Body Cardio^{™}. Cette solution permet effectivement d'obtenir un contact électrique entre les électrodes et les circuits électroniques. Cependant, les trous génèrent un risque d'infiltration d'eau ou de contaminants dans le socle pouvant endommager les circuits électroniques. En outre, le procédé de fabrication du pèse-personne est relativement complexe, comprenant une étape de perçage des trous, de soudure des fils, ainsi que des étapes destinées à limiter le risque d'infiltration.

Le document US2003/0149374 décrit un pèse-personne avec des électrodes sur un substrat et des traces conductrices passant par un bord du substrat. De la même façon, le document US9943241 décrit de faire passer les électrodes autour du bord de la balance. Cependant, aucun de ces documents ne donne de détails sur la façon de réaliser une telle configuration.

Le document FR 2 875 599 décrit un pèse-personne impédancemètre comportant un plateau de mesure supporté par une base de pesée, le plateau de mesure étant muni d'au moins deux électrodes. Le document WO2017/079794 décrit un dispositif de mesure avec un boîtier comprenant deux paires d'électrodes espacées pour les pieds.

Il existe donc un besoin pour un dispositif de mesure et un procédé de fabrication d'un tel dispositif de mesure ne présentant pas au moins certains des inconvénients présentés ci-dessus.

### Résumé

Il est notamment proposé un dispositif de mesure électronique selon la revendication 1 comprenant
- une plaque de mesure, s'étendant le long d'un plan de mesure et comprenant : une face supérieure configurée pour recevoir des pieds d'un utilisateur, une face inférieure, opposée à la face supérieure, et un bord arrondi reliant la face supérieure à la face inférieure ; et
- au moins une électrode s'étendant sur la plaque de mesure, depuis la face supérieure jusqu'à la face inférieure en passant sur le bord arrondi.

Il est ainsi possible d'assurer une bonne conduction électrique de l'électrode entre la face supérieure et la face inférieure de la plaque de mesure en évitant de devoir percer la plaque de mesure et/ou d'ajouter des inserts ou des pièces métalliques. La face supérieure peut ainsi être entièrement plane et uniforme, ce qui permet un nettoyage plus simple.

Les caractéristiques exposées dans les paragraphes suivants peuvent, optionnellement, être mises en oeuvre, indépendamment les unes des autres ou en combinaison les unes avec les autres.

Le bord arrondi peut être une surface convexe. Le bord arrondi peut être dépourvu de portions aveugles. Il est possible de fabriquer le dispositif de mesure par application en deux étapes de de matériau conducteur, sur chacune des faces de la plaque de mesure, chaque application pouvant recouvrir une portion du bord arrondi. Le procédé de fabrication est alors plus simple, rapide et économique qu'un procédé requérant une application individuelle de chaque face et d'un ou plusieurs bords de la plaque.

Le bord arrondi peut être tangent à la face supérieure et à la face inférieure. La continuité électrique de l'électrode peut être favorisée, l'électrode étant formée sur des surfaces qui ne présentent pas d'arête ou de changement de direction brusque.

Le bord arrondi peut avoir une section en arc de cercle.
Le bord arrondi peut présenter une bonne continuité de surface, améliorant encore la conduction électrique de l'au moins une électrode entre la face supérieure et la face inférieure.

Le dispositif peut comprendre une pluralité d'électrodes, dans lequel chaque électrode peut former une bande s'étendant depuis la face supérieure à la face inférieure en passant par le bord arrondi, et les bandes sont par exemple parallèles entre elles. Ainsi, par la multiplication du nombre d'électrodes, la précision des mesures effectuées sur l'utilisateur peut être améliorée. L'arrangement des électrodes en bandes participe à un meilleur contact entre les pieds de l'utilisateur et les électrodes. Les pieds peuvent venir au contact de plusieurs électrodes quelle que soit la position de l'utilisateur sur le dispositif de mesure.

L'au moins une électrode peut être formée par un revêtement sur la plaque de mesure. L'épaisseur du revêtement peut être comprise entre environ 100 nm et environ 300 nm. Il est ainsi possible de rendre la ou les électrodes discrètes, sans compromettre la conductivité des électrodes et en améliorant l'esthétique du dispositif de mesure.

L'au moins une électrode peut être en oxyde d'indium d'étain (ITO), en acier, en nickel ou en alliage de cuivre. Ces matériaux présentent une bonne conductivité même lorsque qu'ils forment des électrodes de faible épaisseur. Ces matériaux participent ainsi à la bonne conduction électrique de la ou des électrodes sans compromettre l'esthétique du dispositif. De tels matériaux sont également adaptés à un procédé de fabrication du dispositif comprenant deux étapes d'application du matériau, sur chacune des faces de la plaque de mesure. De préférence, l'électrode est l'oxyde d'indium d'étain, ce matériau présentant de meilleures propriétés de conductivité et étant adapté à une application par pulvérisation magnétron.

Le dispositif peut comprendre en outre au moins un circuit imprimé disposé en regard de la face inférieure de la plaque de mesure, l'au moins un circuit imprimé peut comprendre au moins un connecteur électrique s'étendant vers la face inférieure pour venir au contact de l'au moins une électrode. Il est ainsi possible d'assurer la continuité électrique depuis les électrodes vers les circuits imprimés. En particulier, les contacts à ressorts fournissent une connexion fiable en limitant l'introduction de bruit dans la transmission. Ils peuvent être facilement et rapidement montés sur le circuit imprimé (par exemple par soudage).

Le dispositif peut en outre comprendre au moins une cellule de charge solidaire de la plaque de mesure pour déterminer une valeur de poids de l'utilisateur. La ou les cellules de charges peuvent être montées sur la plaque de mesure.
Le dispositif peut comprendre quatre cellules de charge, permettant de déterminer une valeur du poids de l'utilisateur plus précise. La ou les cellules de charge peuvent mesurer, outre une valeur de poids, le décentrage de l'utilisateur sur le dispositif de mesure.

Le dispositif peut comprendre en outre une plaque de support solidaire de la face inférieure de la plaque de mesure, la plaque de support étant agencée pour permettre le montage de composants électroniques du dispositif. Il est possible d'assembler le dispositif par montage de l'ensemble de l'électronique du dispositif sur la plaque de support et par solidarisation de la plaque de support sur la plaque de mesure (par exemple par vissage ou collage). Ce procédé est plus rapide et plus efficace qu'un procédé dans lequel les composants électroniques sont montés directement et individuellement sur la plaque de mesure.

Le dispositif peut en outre comprendre un socle, la plaque de mesure pouvant être en retrait par rapport au socle (lorsque le dispositif de mesure est vu de dessus, le long d'un axe orthogonal au plan de mesure). La plaque de mesure peut être en retrait au moins au niveau du bord arrondi sur lequel s'étend l'au moins une électrode. Le socle peut ainsi être surdimensionné par rapport à la plaque de mesure (au moins au niveau des électrodes). Les bords du socle dépassent (lorsque vus du dessus) par rapport au bord arrondi de la plaque de mesure, et peuvent protéger le bord arrondi de contraintes externes, tels que les chocs ou les frottements. On limite ainsi les risques de dégradation des électrodes par de telles contraintes.

L'écart entre la plaque de mesure et le socle, mesuré selon la largeur de la plaque de mesure, peut être compris entre 0,4 mm et 2 cm, voire entre 0,4 mm et 1 cm, voire entre 0,4 mm et 2 mm. Un faible écart permet au dispositif de mesure de maintenir une sorte d'unité structurelle (impression monolithique) et ainsi de ne pas présenter de forme qui limite sa préhension par un utilisateur. Le faible écart assure néanmoins une fonction de pare-choc, par exemple contre un mur de la salle de bain où se trouve généralement la balance. Alternativement, l'écart peut être plus important, par exemple compris entre 1 mm et 2cm ou encore 0,5cm et 1cm.

Au moins une électrode peut s'étendre sur la face inférieure sur au moins 5 cm, voire au moins 10 cm, voire au moins 20 cm. Comme la face inférieure n'est pas visible, le motif des électrodes peut être conçu pour agencer les connecteurs de façon optimale. En particulier, un seul circuit imprimé peut être prévu pour reprendre le contact avec toutes les électrodes, sans que la taille du circuit imprimé ne soit augmentée. Le circuit imprimé peut être une carte principale d'une unité de commande du dispositif de mesure.

Le dispositif peut comprendre en outre au moins un module de communication sans fil (par exemple pour une communication bidirectionnelle) à destination d'un dispositif à proximité.
Le dispositif est un appareil connecté. L'utilisateur peut accéder aux mesures effectuées par le dispositif depuis son terminal mobile (ou smartphone en anglais). Le terminal mobile peut notamment avoir des capacités de traitement, de mémoire et d'affichage étendues, de sorte que l'interaction de l'utilisateur avec le dispositif peut être améliorée (par exemple en permettant un suivi de mesures, un contrôle du dispositif et/ou une identification de l'utilisateur).

Selon un autre aspect, il est proposé un procédé de fabrication selon la revendication 11 d'un dispositif de mesure, comprenant les étapes de :
- fourniture d'une plaque, dite plaque de mesure, comprenant : une face supérieure, configurée pour recevoir des pieds d'un utilisateur; une face inférieure, opposée à la face supérieure, et un bord arrondi reliant la face supérieure à la face intérieure ;
- dépôt d'une couche d'au moins un matériau conducteur sur la face supérieure, le bord arrondi et la face inférieure pour former au moins une électrode.

Un tel procédé permet d'obtenir une bonne conduction électrique de l'électrode entre la face supérieure et la face inférieure de la plaque de mesure.

L'étape de dépôt peut comprendre un premier dépôt de matériau conducteur sur la face supérieure et une première portion du bord arrondi ; un deuxième dépôt de matériau conducteur sur la face inférieure et une deuxième portion du bord arrondi, de sorte qu'il y ait une continuité de matériau conducteur entre la première portion du bord arrondi et la deuxième portion du bord arrondi. Chaque dépôt de matériau conducteur peut s'étendre sur une portion du bord arrondi pour assurer la conduction électrique entre la face supérieure et la face inférieure de la plaque de mesure. Le procédé de fabrication est alors plus simple, rapide et économique qu'un procédé requérant une application individuelle de chaque face et d'un ou plusieurs bords de la plaque.

Le procédé peut comprendre en outre une étape de suppression de matériau conducteur excédentaire de la face supérieure, du bord arrondi et de la face inférieure. Une telle étape permet de retirer l'excèdent de matériau conducteur pour former les électrodes et fournir une plaque de mesure esthétique. De préférence, l'étape de suppression peut être effectuée par gravure chimique.

L'étape de dépôt peut être composée uniquement du premier dépôt et du deuxième dépôt.

L'étape de dépôt peut être un dépôt en phase vapeur, par évaporation ou pulvérisation magnétron. Le dépôt est particulièrement adapté à la formation des électrodes. De préférence, le procédé est un dépôt par pulvérisation magnétron, qui permet de manipuler des objets de dimensions plus importante.

### Brève description des dessins

D'autres caractéristiques, détails et avantages apparaîtront à la lecture de la description détaillée ci-après, et à l'analyse des dessins annexés, sur lesquels :
**Fig. 1**

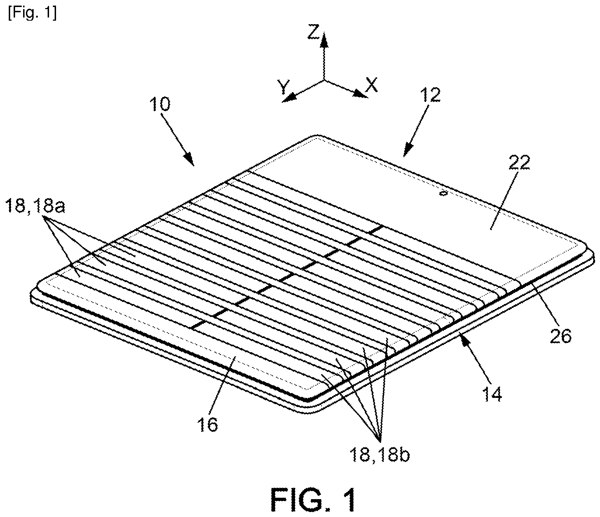

   La figure 1 montre une vue en perspective du dessus d'un dispositif de mesure selon un mode de réalisation.
**Fig. 2**

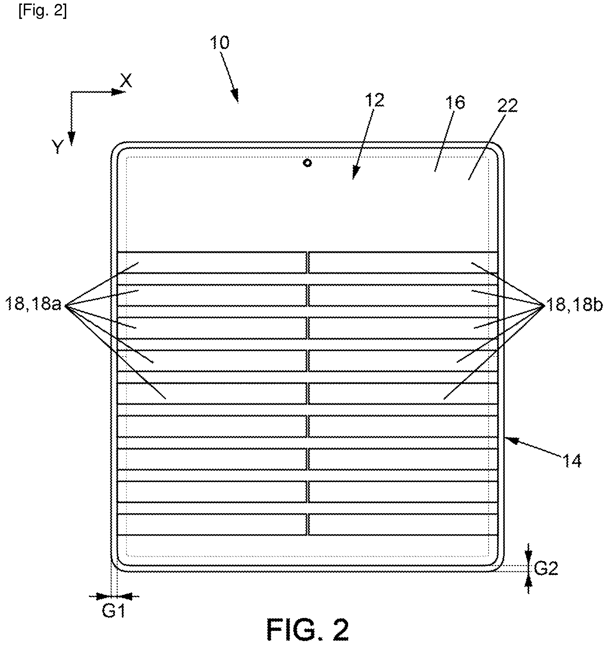

   La figure 2 montre une vue du dessus du dispositif de mesure de la figure 1 selon un mode de réalisation.
**Fig. 3**

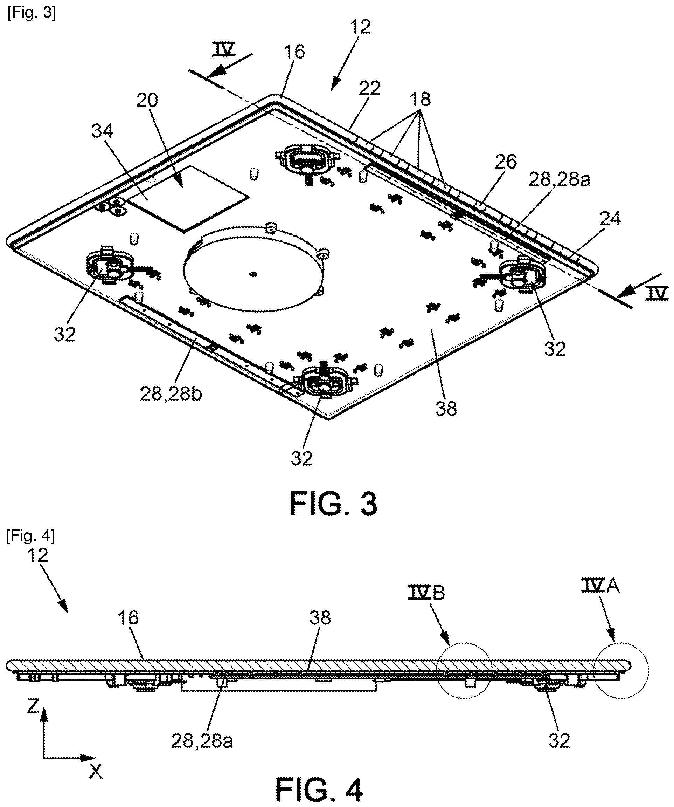

   La figure 3 montre une vue en perspective du dessous d'une unité de mesure pouvant être mise en oeuvre dans le dispositif de mesure de la figure 1 selon un mode de réalisation (socle non représenté).
**Fig. 4**

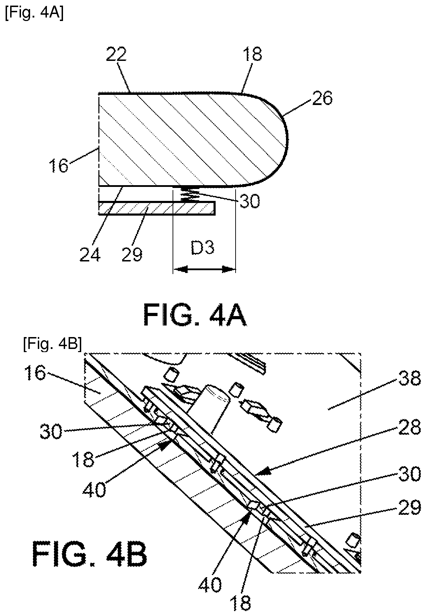

   La figure 4 montre une section de l'unité de mesure de la figure 3, selon le plan xz.
**Fig. 4A**
   La figure 4A illustre schématiquement un premier détail de la figure 4.
**Fig. 4B**
   La figure 4B illustre schématiquement un deuxième détail de la figure 4.
**Fig. 5**

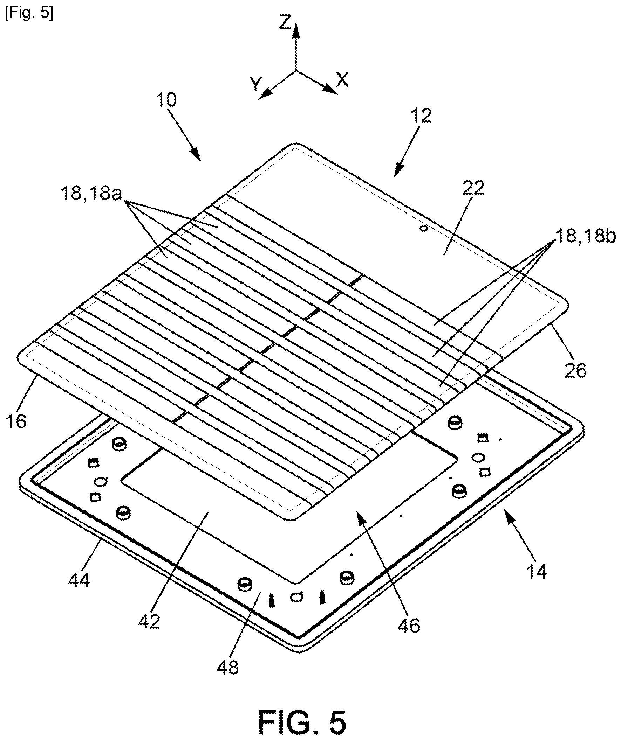

   La figure 5 montre une vue explosée du dessus du dispositif de mesure de la figure 1 selon un mode de réalisation.
**Fig. 6**

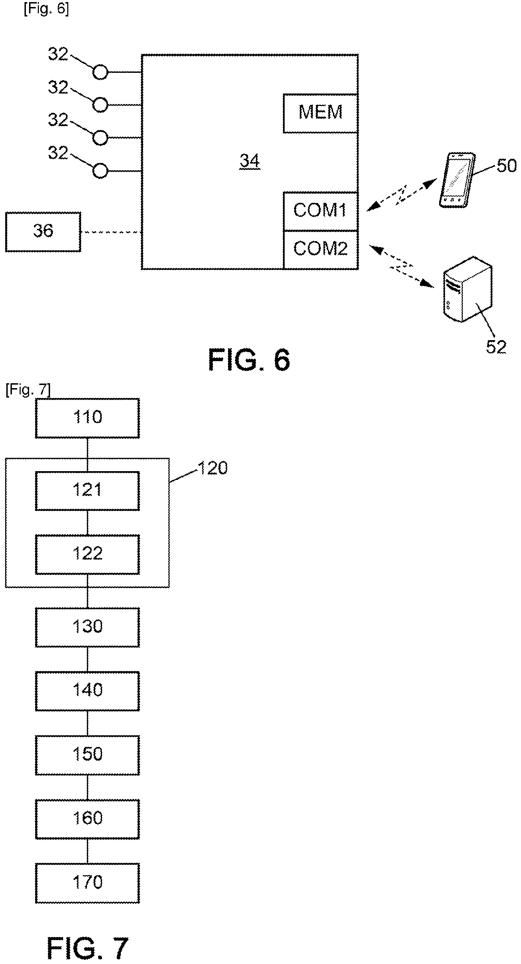

   La figure 6 illustre schématiquement une unité de commande du dispositif de mesure de la figure 1 selon un mode de réalisation.
**Fig. 7**
   La figure 7 montre un organigramme d'un procédé de fabrication du dispositif de mesure de la figure 1 selon un mode de réalisation.

### Description des modes de réalisation

La figure 1 illustre de manière schématique un dispositif de mesure 10 pour effectuer des mesures biométriques sur un utilisateur. Par exemple, le dispositif de mesure 10 peut effectuer une mesure du poids (ou de masse) de l'utilisateur, des mesures d'impédance (analyse de bio-impédance, BIA, ou analyse de pléthysmographie d'impédance, IPG), d'électrocardiogrammes (ECG) et/ou de détecter des neuropathies.

Lorsque le dispositif de mesure 10 permet de mesurer un poids, on parlera de pèse-personne électronique mais il est possible d'avoir un dispositif de mesure 10 ne permettant pas de mesurer le poids.

Selon l'exemple illustré, le dispositif de mesure 10 a une forme extérieure globalement carrée (vue du dessus, en Z). Cependant, le dispositif de mesure 10 pourrait prendre toute forme souhaitée. Le dispositif de mesure 10 peut être de forme rectangulaire, ovale, ronde ou toute autre variante.

Le dispositif de mesure 10 comprend essentiellement, tel qu'illustré, une unité de mesure 12 et un socle 14. L'unité de mesure 12 est destinée à la détermination des mesures biométriques de l'utilisateur. L'unité de mesure 12 peut notamment comporter une plaque de mesure 16, au moins une électrode 18 et un ensemble électronique 20. La plaque de mesure 16 est configurée pour recevoir les pieds d'un utilisateur. Le socle 14 et la plaque de mesure 16 définissent un volume interne 46 qui loge l'ensemble électronique 20 (voir figure 5).

Dans un mode de réalisation, le socle 14 peut reprendre les efforts reçus par la plaque de mesure 16, via des cellules de charge 32. Dans un autre mode de réalisation (non illustré), le socle 14 peut servir uniquement de boitier pour définir le volume interne 46 et des pieds peuvent reprendre les efforts reçus par la plaque de mesure 16. Ces deux variantes sont connues et ne seront pas détaillées ici.

### 1. Plaque de pesage 16

La plaque de mesure 16 est ici une plaque plane rigide s'étendant le long d'un plan de mesure xy. L'utilisateur peut se placer sur la plaque de mesure 16, et la rigidité de la plaque 16 assure une résistance aux contraintes appliquées par l'utilisateur.

On note que la plaque de mesure 16 illustrée est, vue du dessus (parallèle au plan de mesure xy, le long de la direction z), de forme sensiblement carrée, mais la plaque de mesure 16 pourrait prendre toute autre forme, telle que rectangulaire, ovale ou ronde. La plaque de mesure 16 peut comporter des bords courbés, droits ou une combinaison des deux.

La plaque de mesure 16 comporte une face supérieure 22 et une face inférieure 24, reliées entre-elles par un bord 26. En particulier, dans un mode de réalisation, le bord 26 est arrondi. Par arrondi, il est signifié que le bord 26 ne présente pas d'arête, à tout le moins d'arête fortement marquée.

La face supérieure 22 est parallèle au plan de mesure xy et forme une surface extérieure du dispositif de mesure 10. La face supérieure 22 est destinée à recevoir les pieds d'un utilisateur lorsque l'utilisateur se place sur la plaque de mesure 16. La face supérieure 22 entre au contact des pieds de l'utilisateur.

La face inférieure 24, qui peut également être parallèle au plan de mesure xy, est opposée à la face supérieure 22. La face inférieure 24 forme une surface interne du dispositif de mesure 10. En particulier, la face inférieure 24 délimite une portion du volume interne 46 logeant l'ensemble électronique 20. La face inférieure 24 peut ainsi interagir avec l'ensemble électronique 20.

Le bord arrondi 26 forme une jointure entre la face supérieure 22 et la face inférieure 24. Le bord arrondi 26 s'étend selon la direction normale au plan de mesure xy (direction z illustrée sur la figure 1), depuis une bordure de la face supérieure 22 jusqu'à une bordure de la face inférieure 24.

L'au moins une électrode 18 s'étend depuis la face supérieure 22 jusqu'à la face inférieure 24, en passant sur le bord 26, qui peut être arrondi (comme décrit précédemment). L'électrode 18 est agencée pour être en contact avec un pied de l'utilisateur au niveau de la face supérieure 22.

Dans l'exemple illustré, le bord arrondi 26 s'étend sur toute la périphérie de la plaque de mesure 16. Cependant, dans une variante, le bord arrondi 26 peut s'étendre sur une ou plusieurs portions de la périphérie de la plaque de mesure 16. Par exemple, le bord arrondi 26 pourrait s'étendre sur deux côtés opposés d'une plaque de mesure 16 carrée ou rectangulaire. Dans un mode de réalisation, le bord n'est arrondi qu'aux endroits où se trouve une électrode 18.

Le bord arrondi 26 est ici une surface convexe, c'est-à-dire que le bord arrondi 26 est bombé vers l'extérieur par rapport aux bordures des faces supérieure et inférieure 22, 24. Le bord arrondi 26 est dépourvu de portions aveugles. Autrement dit, l'ensemble du bord arrondi 26 est visible lorsque la plaque de mesure 16 est représentée par une vue de dessus et une vue de dessous (lorsque l'on regarde le plan de mesure xy depuis une direction le long de z). Comme cela sera décrit plus en détail plus loin, une telle surface convexe facilite la formation d'une ou plusieurs électrodes 18 sur la plaque de mesure 16.

Comme plus visible sur la figure 4a, la surface convexe formant le bord arrondi 26 est ici tangente à la bordure de la face supérieure 22 et à la bordure de la face inférieure 24. Dès lors, le raccordement entre la face supérieure 22 ou inférieure 24 et le bord arrondi 26 est continu. La transition entre l'une ou l'autre des faces 22, 24 et le bord arrondi 26 est dépourvue d'arête ou de changement de direction brusque. La continuité électrique d'une électrode 18 s'étendant depuis la face supérieure 22 vers la face inférieure 24 en passant par un tel bord arrondi 26 est améliorée.

En outre, ici, le bord arrondi 26 a une section en arc de cercle (ou sensiblement en arc de cercle) dans un plan normal au plan de mesure xy (et parallèle à la direction x ou y, en fonction du bord observé). Cette caractéristique améliore encore la continuité de surface du bord arrondi 26, favorisant la continuité électrique de l'électrode 18. Cependant, le bord arrondi 26 pourrait également avoir une section elliptique, par exemple pour faciliter la fabrication de la plaque 16. Dans une variante, le bord arrondi 26 présente des coins (la jonction entre la face supérieure 22 et le bord 26 et la jonction entre la face inférieure 24 et le bord 26) arrondis reliés par une surface plane (parallèle à l'axe z). Cette variante peut néanmoins présenter des portions aveugles (la surface plane). Plus généralement, toute section convexe dont le bord est dérivable (c'est à dire sans arête) peut convenir.

La plaque de mesure 16 peut être en verre, mais peut également être en métal, plastique (par exemple en Plexigas^{™}), en aluminium (par exemple aluminium anodisé), en matériau composite, ou tout autre matériau accessible à l'homme du métier. Les dimensions de la plaque de mesure 16 peuvent être choisies de sorte à conférer à la plaque 16 une rigidité suffisante pour résister aux contraintes appliquées par l'utilisateur se plaçant sur la plaque de mesure 16. Les contraintes peuvent alors être mesurées par l'unité électronique 20, en particulier à l'aide d'au moins une cellule de charge, pour déterminer le poids ou un éventuel décentrage de l'utilisateur sur le dispositif de mesure 10.

### 2. Electrodes 18

L'électrode 18 est un contact externe sur la plaque de mesure 16. Elle forme un passage conducteur d'électricité entre la face supérieure 22 (à destination des pieds de l'utilisateur) et la face inférieure 24 (à destination de l'ensemble électronique 20). Plus spécifiquement, l'au moins une électrode 18 s'étend sur la plaque de mesure 16, depuis la face supérieure 22 jusqu'à la face inférieure 24 en passant par le bord arrondi 26. La ou les électrodes 18 peuvent permettre de faire circuler un courant électrique entre une borne sur la face supérieure 22 et une borne sur la face inférieure 24 de la plaque de mesure 16, d'y appliquer une tension, et/ou de récupérer un signal électrique provenant de l'utilisateur (type ECG). La ou les électrodes 18 participent ainsi aux mesures d'impédance, à la détermination d'électrocardiogrammes et/ou à la détection de neuropathies. Du fait du passage de l'électrode 18 par le bord 26, la plaque de mesure 16 peut être dépourvue de trous pour le passage de fils conducteurs assurant la transmission du courant depuis la face supérieure 22 vers la face inférieure 24. La plaque de mesure 16 peut ainsi être une surface sans orifices, limitant le risque infiltration d'eau ou de contaminants dans le dispositif de mesure 10 et formant une plaque esthétique. La plaque de mesure 16 peut en outre être totalement plane ou plate, ce qui facilite son nettoyage.

Comme visible sur la figure 2, un premier groupe d'électrodes 18a et un deuxième groupe d'électrodes 18b s'étendent sur la plaque de mesure 16. Par ailleurs, certaines bandes de matériau peuvent ne pas être reliées électriquement (considération esthétique uniquement). Le premier groupe d'électrodes 18a est destiné à entrer en contact avec le pied gauche de l'utilisateur, et le deuxième groupe d'électrodes 18b est destiné à rentrer en contact du pied droit. Parmi chaque groupe d'électrodes 18a, 18b, une ou plusieurs électrodes 18 peut émettre un courant ou recevoir un courant et/ou mesurer un potentiel. Des configurations des électrodes 18 permettant de réaliser de l'impédancemétrie ou de l'ECG sont connues et ne seront pas décrites ici.

La distance minimale entre le premier groupe d'électrodes 18a et le deuxième groupe d'électrode 18b (sur la figure 2, mesurée selon la largeur de la plaque de mesure 16, c'est-à-dire la direction x, du fait de la configuration deux groupes d'électrodes 18a, 18b en vis-à-vis), peut être comprise entre 1 et 4 mm, et/ou être de 2mm. Pour limiter les interférences entre les premier et deuxième groupes d'électrodes 18a, 18b, cette distance peut être augmentée.

En variante, un seul groupe d'électrodes 18 pourrait être prévu sur la plaque de mesure 16, une autre électrode ou groupe d'électrodes pouvant être distinct de la plaque de mesure 16..

De retour sur la figure 2, chaque groupe d'électrodes 18a, 18b comprend ici une pluralité d'électrodes 18 (par exemple deux électrodes par groupe ou plus de deux électrodes par groupe), de sorte à augmenter la précision des mesures d'impédance. Il n'est toutefois pas exclu que chaque groupe d'électrodes 18a, 18b comprenne une unique électrode 18.

Comme illustré en figure 1 notamment, chaque électrode 18 peut s'étendre sensiblement dans un sens de la largeur de la plaque de mesure 16 (direction x telle qu'illustrée en figure 2) depuis le milieu de la face supérieure 22, pour assurer un contact avec le pied de l'utilisateur. En outre, chaque électrode 18 s'étend sur la face inférieure 24 sur au moins 1 cm depuis l'extrémité de la plaque de mesure 16 (distance D3 sur la figure 4a). On assure ainsi que le courant circulant dans l'électrode 18 peut être transmis depuis ou vers l'ensemble électronique 20, par exemple en laissant la place pour le montage d'un connecteur électrique 30 entre la face inférieure 24 et l'ensemble électronique 20.

Chaque électrode 18 peut prendre la forme d'une bande, les bandes de chacun des premier et deuxième groupes 18a, 18b étant par exemple parallèles entre elles. L'arrangement des électrodes 18 en bandes participe à un meilleur contact entre les pieds de l'utilisateur et les électrodes 18. Les pieds de l'utilisateur peuvent venir au contact de plusieurs électrodes 18 quelle que soit la position de l'utilisateur sur le dispositif de mesure 10.

Alternativement, chaque électrode 18 peut prendre la forme d'un carré ou d'un rectangle qui s'étend jusqu'au bord 26. Alternativement, les électrodes ont des formes différentes.

Chaque électrode 18 est typiquement formée par revêtement sur la plaque de mesure 16. Comme il sera décrit plus en détail plus loin, le bord arrondi 26 de la plaque de mesure 16 est particulièrement adapté à la formation des électrodes par revêtement. De plus, le bord arrondi 26, sans arête, permet d'améliorer la tenue du revêtement sur la plaque de mesure 16 et de minimiser les risques de perte de contact qu'il pourrait y avoir au niveau d'une arête. En effet, sur une arête, l'épaisseur du revêtement peut être plus faible (car le contact avec la plaque de mesure 16 est plus limité à cause de la forte courbure locale) et le revêtement peut alors être plus facilement exposé à l'usure ou aux coups.

Chaque électrode 18 peut être en oxyde d'indium d'étain (ITO), en acier, en nickel, ou en un alliage de cuivre, ou en un autre matériau approprié. En l'espèce ces matériaux présentent une bonne conductivité même lorsque des électrodes 18 de faible épaisseur sont formées. Chaque électrode 18 (formée par revêtement) peut avoir une épaisseur comprise entre 100 nm et 300 nm et/ou une résistance au carré inférieure à 75 Ohm/carré (+/- 15 Ohm/carré). Ces matériaux participent à la bonne conduction électrique de la ou des électrodes 18 sans compromettre l'esthétique du dispositif de mesure 10.

Dans un mode de réalisation, la ou les électrodes 18 peuvent être réalisée en un premier matériau sur la face supérieure 22 et en un deuxième matériau, différent du premier matériau, sur la face inférieure 24. La jonction entre les matériaux peut se faire sur le bord 26 (voir le procédé décrit plus en détail plus bas). De l'ITO peut être utilisé comme premier matériau, sur la face supérieure 22, car il est transparent et participe ainsi l'esthétique de l'extérieur du dispositif de mesure 10. De plus, un dispositif de mesure 10 sobre peut contribuer à augmenter le taux de rétention par les utilisateurs, étant donné que ces derniers n'ont pas l'impression d'utiliser un dispositif de mesure sophistiqué qui peut contribuer à la détection de maladies ou des conditions physiques. Le second matériau, utilisé sur la face inférieure 24, peut être plus simple d'application et/ou moins cher. En effet, il n'y a pas de considérations esthétiques sur la face inférieure 24 (par exemple la transparence du revêtement). Cet autre matériau peut être une peinture conductrice ou un matériau standard déposé par PVD.

Les électrodes 18 peuvent s'étendre sur la face inférieure 24 sur une distance comprise entre 1cm et 20 cm (depuis le bord vers la partie du milieu de la face inférieure 24). Pour simplifier l'assemblage avec les connecteurs et éviter que ces derniers ne soient trop proches du bord 26, une distance d'au moins 4cm peut être choisie. Dans un mode de réalisation, les connecteurs 30 sont positionnés le plus au centre possible de la balance. Alternativement, les électrodes sont agencées sur la face inférieure 24 de façon à ce que les connecteurs 30 soient intégrés dans un espace le plus petit possible (les connecteurs des deux groupes d'électrodes), pour pouvoir par exemple être connectés à une unique carte, dite carte principale, qui sera décrite par la suite. La face inférieure 24 n'étant pas visible, la liberté d'agencement des électrodes est particulièrement grande et permet ainsi d'optimiser l'architecture.

### 3. Ensemble électronique 20

L'ensemble électronique 20 est positionné dans le volume interne 46 formé par la plaque de mesure 16 et le socle 14. L'ensemble électronique 20 s'étend au regard de la face inférieure 24 pour interagir avec la plaque de mesure 16 et l'au moins une électrode 18.

L'ensemble électronique 20 comprend notamment au moins un circuit imprimé 28, au moins une cellule de charge 32 et une unité de commande 34. Les circuits imprimés 28 participent à la transmission du courant électrique depuis et vers les électrodes 18. Les cellules de charge 32 permettent de mesurer les efforts appliqués par l'utilisateur placé sur la plaque de mesure 16, notamment pour effectuer une mesure du poids ou déterminer un éventuel décentrage de l'utilisateur par rapport à la plaque de mesure 16. Les cellules de charge 32 peuvent aussi permettre d'effectuer un BCG. L'unité de commande 34 peut assurer la centralisation et la coordination de l'ensemble électronique 20 et assurer une communication vers l'utilisateur. L'unité de commande 34 peut être montée sur une carte, dite carte principale.

Comme plus visible sur la figure 3, un premier circuit imprimé 28a et un deuxième circuit imprimé 28b s'étendent au regard de la face inférieure 24 de la plaque de mesure 16. Le premier circuit imprimé 28a s'étend au regard du premier groupe d'électrodes 18a, pour entrer au contact avec chaque électrode 18 du premier groupe d'électrodes 18a. Par ailleurs, le deuxième circuit imprimé 28b s'étend au regard du deuxième groupe d'électrodes 18b, de sorte à entrer au contact avec chaque électrode 18 du deuxième groupe d'électrodes 18b. Dans une variante déjà mentionnée précédemment, un seul circuit imprimé est prévu pour reprendre le contact pour les deux groupes d'électrodes. Ce circuit imprimé peut être directement la carte principale, ce qui permet de diminuer le nombre de pièces et donc de simplifier le montage et de baisser les coûts. Cette variante est particulièrement applicable avec des électrodes qui s'étendent sur la face inférieure 24 jusqu'au 10cm sur la face inférieure 24 (par exemple au moins jusqu'environ au centre de la plaque de mesure 16).

Comme illustré sur les figures 4a et 4b, chaque circuit imprimé 28 comprend une carte de circuit 29 (« *Printed Circuit Board* », PCB, en anglais) sur laquelle sont soudées un ou plusieurs connecteurs électriques 30. Les connecteurs 30 sont, sur les figures, des contacts à ressort 30 (type « *spring finger* »*,* c'est-à-dire une lame contrainte). En l'espèce, chaque connecteur 30 s'étend depuis la carte de circuit 29 jusqu'à l'électrode 18. Chaque connecteur 30 assure la connexion électrique entre la carte de circuit 29 et l'électrode 18. En particulier, les contacts à ressorts 30 fournissent une connexion électrique stable en limitant l'introduction de bruit dans la transmission du courant, et sont facile à monter sur la carte de circuit 29 (notamment par soudage). Toutefois, en variante, le connecteur 30 peut être un fil pour relier la carte 29 à chaque électrode 18. En variante, des matériaux élastomères conducteurs peuvent être utilisés (qui sont par exemple légèrement comprimés entre la carte de circuit 29 et la face inférieure 24 pour assurer le contact électrique).

Sur la figure 3, quatre cellules de charge 32 sont disposées au voisinage de chacun des quatre coins du dispositif de mesure 10. En variante, lorsque le dispositif de mesure 10 a une forme ronde ou ovale, quatre cellules de charge 32 pourraient être régulièrement répartis autour d'un l'axe médian du dispositif de mesure 10. On choisira de préférence des cellules de charge 32 comprenant deux jauges de déformation, en particulier des jauges comprenant un premier élément dont la résistance augmente sous l'effet d'une compression verticale appliquée au pied considéré et un deuxième élément dont la résistance diminue sous l'effet de ladite compression verticale. Les cellules de charge 32 reprennent les efforts entre la plaque de mesure 16 et le socle 14. Alternativement, comme décrit plus haut, les cellules de charge 32 peuvent reprendre les efforts entre la plaque de mesure 16 et un ou plusieurs pieds (par exemple une cellule de charge par pied). Le socle 14 peut alors être mécaniquement solidaire de la plaque de mesure 16.

Comme illustré schématiquement à la figure 6, l'unité de commande 34 est reliée à chaque circuit imprimé 28 et chaque cellule de charge 32. L'unité de commande 34 peut être reliée au moyen de nappes de connexion et/ou de fils. L'unité de commande 34 peut interagir avec chaque électrodes 18 et chaque cellule de charge 32 pour déterminer une ou plusieurs informations telles que le poids, le décentrage, une mesure d'impédance, un électrocardiogramme et/ou une éventuelle neuropathie. L'unité de commande 34 peut en outre être reliée à un afficheur 36 du dispositif de mesure 10, pour interagir avec l'utilisateur, par exemple en affichant les informations déterminées.

L'unité de commande électronique 34 peut comprendre un premier module de communication sans-fil COM1 de courte portée. Le premier module de communication COM1 exploite un réseau local, par exemple de type Bluetooth, Low-Energy Bluetooth (BLE) et/ou Wi-fi. Le premier module de communication COM1 communique avec un dispositif à proximité 50 du dispositif de mesure 10. Le dispositif à proximité 50 peut par exemple être un terminal mobile (« *smartphone* » en anglais), une montre connectée ou tout autre dispositif associé à l'utilisateur. Le premier module de communication sans-fil COM 1 peut permettre une identification de l'utilisateur se plaçant sur le dispositif de mesure 10, une réception de commandes de la part de l'utilisateur ou encore la transmission d'une ou plusieurs informations déterminées par le dispositif de mesure 10 vers le dispositif à proximité 50.

L'unité de commande électronique 34 peut comprendre un deuxième module de communication sans-fil COM2. Le deuxième module de communication COM2 peut être prévu en complément ou en substitution du premier module de communication COM1. Le deuxième module de communication COM2 exploite le réseau cellulaire, par exemple GSM, 3G, 4G(-LTE), LTE-M, 5G ou tout réseau cellulaire dédié aux objets connectés. Le deuxième module de communication COM2 donne au dispositif de mesure 10 une interface de communication vers un serveur distant 52. Les informations déterminées par le dispositif de mesure 10 peuvent être envoyées vers le serveur distant 52. Les informations peuvent ensuite être rendues accessibles à l'utilisateur depuis tout appareil adapté à se connecter au serveur 52, par exemple le smartphone de l'utilisateur, d'un médecin ou un ordinateur.

L'unité de commande 34 comprend en outre une mémoire MEM. La mémoire MEM peut stocker une pluralité d'informations, par exemple les informations déterminées par le dispositif de mesure 10 ou des informations reçues du dispositif à proximité 50 et/ou du serveur distant 52. La pluralité d'informations peut être envoyée périodiquement vers le serveur 52, par exemple une fois par semaine. La fréquence d'utilisation du deuxième module de communication COM2 peut être réduite, réduisant la consommation d'énergie de l'unité de commande 34.

L'ensemble électronique 20 du dispositif de mesure 10 peut être alimenté par une batterie, par exemple une batterie de type lithium-ion. La batterie peut être reçue avec l'ensemble électronique 20 dans le volume interne 46 définit par la plaque de mesure 16 et le socle 14.

L'ensemble électronique 20 est ici monté sur une plaque de support 38 pour faciliter l'assemblage du dispositif de mesure 10. La plaque de support 38 est solidaire de la plaque de mesure 16. La plaque de support 38 peut par exemple être une pièce plastique collée sur la face inférieure 24 de la plaque de support 38, de sorte à éviter tout perçage de la plaque de mesure 16. La plaque de mesure 16 est dépourvue d'orifices, et le risque d'infiltration d'eau ou de contaminant pouvant endommager l'ensemble électronique 20 est réduit. Toutefois, en alternative, les composants de l'ensemble électronique 20 pourraient être solidaires du socle 14.

Les composants de l'ensemble électronique 20 peuvent être vissés sur la plaque de support 38. Comme visible sur la figure 3, la plaque de support 38 peut présenter des logements pour recevoir les cellules de charge 32. En outre, comme visible sur la figure 3, la plaque de support 38 peut présenter des ouvertures 40 au regard de chaque électrode 18 pour permettre le passage des contacts à ressort 30.

### 4. Socle 14

Le socle 14 forme une base pour recevoir l'unité de mesure 12. Dans un mode de réalisation où le dispositif de mesure 10 est un pèse-personne, l'unité de mesure 12 est légèrement mobile par rapport au socle 14 selon la direction normale au plan de mesure xy (direction z illustrée sur les figures 1 et 5). Une telle mobilité permet de mesurer le déplacement de la plaque de mesure 16 lorsque l'utilisateur se place sur le dispositif de mesure 10, permettant notamment une estimation du poids et/ou du décentrage de l'utilisateur.

Comme illustré sur la figure 5, le socle 14 forme ici une embase sur laquelle est surmontée l'unité de mesure 12. En variante, le socle 14 pourrait comprendre quatre pieds disposés sur au voisinage de chaque coin de la plaque de mesure 16.

Dans l'exemple illustré, le socle 14 a ici une forme globalement carrée, correspondant à la forme de la plaque de mesure 16. En l'espèce, le socle 14 pourrait avoir la même forme que la plaque de mesure 16, ou une forme distincte de la plaque de mesure 16. Par exemple, le socle 14 pourrait avoir une forme carrée ou rectangulaire, alors que la plaque de mesure 16 est ovale ou ronde.

Dans un mode de réalisation, particulièrement visible en figure 2, le socle 14 est surdimensionné par rapport à la plaque de mesure 16 selon une vue du dessus du plan de mesure xy (le long de l'axe z). Dans l'exemple illustré, le périmètre de la plaque de mesure 16 est inscrit dans le périmètre du socle 14. Alternativement, le socle 14 peut s'étendre au-delà, dans le plan xy, de la plaque de mesure 16 uniquement au niveau d'un bord arrondi 26. En l'espèce, le surdimensionnement permet de protéger les électrodes 18 d'un éventuel endommagement par choc ou frottement. Toutefois, le socle 14 peut être à l'inverse sous-dimensionné par rapport à la plaque de mesure 16, par exemple pour des considérations esthétiques ou pour légèrement faciliter le ramassage du dispositif de mesure 10 en permettant à l'utilisateur de saisir la plaque de mesure 16.

Dans le cas d'un socle surdimensionné, vu du dessus, le socle 14 peut avoir des dimensions en x (voir l'écart G1 sur la figure 2) et/ou y (voir l'écart G2 sur la figure 2) plus grandes que celles du bord de la plaque de mesure 16, au moins aux emplacements où se trouve une électrode 18. Le socle 14 fonctionne alors comme un pare-choc pour la plaque de mesure 16, en particulier lorsque le dispositif de mesure 10 est déplacée par glissement au sol. D'une part, le socle 14 protège la plaque de mesure 16 des chocs, d'autre part, il protège les électrodes 18 au niveau du bord 26. Dans un mode de réalisation, le socle 14 a des dimensions en x (c'est-à-dire au niveau des bords où se trouvent les électrodes) plus grandes que celles de la plaque de mesure 16 (l'écart G1 donc). Ce mode de réalisation permet de protéger les bords de plaque de mesure 16 où se trouvent les électrodes. Les autres bords, où il n'y pas d'électrodes, peuvent être en retrait de la même façon (voir l'écart G2), ou être à niveau, ou se projeter davantage. Les bords où il n'y a pas d'électrode peuvent ne pas être arrondis. Lorsqu'il y a un surdimensionnement comme décrit précédemment, l'écart G1, G2 entre la plaque de mesure 16 et le socle 14 est typiquement compris entre 0,4 mm et 2 cm, voire entre 0,4 mm et 1 cm, voire entre 0,4 mm et 2 mm. Un faible écart G1, G2 permet de maintenir l'aspect bloc du dispositif de mesure, ce qui est commode pour sa préhension par l'utilisateur, tout en maintenant l'effet pare-choc.

Alternativement, l'écart G1 et/ou G2 peut être plus important, par exemple compris entre 1mm et 2cm ou encore 0,5cm et 1cm.

Comme illustré sur la figure 5, le socle 14 peut comprendre une portion plane 42 et une portion périphérique 44 faisant saillie de la portion plane 42 selon la direction normale au plan de mesure xy, formant bordure. Le socle 14 forme, avec la plaque de mesure 16, le volume interne 46 recevant l'ensemble électronique 20. Le dispositif de mesure 10 comprenant le socle 14 et l'unité de mesure 12 peut présenter une faible épaisseur (selon la direction normale z au plan de mesure xy). Par exemple, l'épaisseur totale du dispositif de mesure 10 peut être inférieure à 3 cm, voire 2,5 cm.

Le socle 14 peut être en plastique ou comprendre du plastique (plastique, plastique renforcé par des fibres, plastique renforcé par une pièce métallique) et/ou être en métal ou comprendre du métal (aluminium, acier, etc.). Les matériaux légers mais solides sont privilégiés.

Une pièce de montage 48 peut être reçue dans le volume interne 46, pour coopérer avec la plaque de support 38 de l'unité de mesure 12. La pièce de montage 48 peut par exemple être une pièce plastique collée dans le volume interne 46 et apte à coopérer avec la plaque de support 38. L'assemblage du dispositif de mesure 10 s'en trouve facilité.

Dans un exemple de réalisation, il peut être prévu une ou plusieurs pièces de montage pour guider mécaniquement la plaque de mesure 16 par rapport au socle 14, pour autoriser un mouvement selon la direction Z tout en empêchant un désalignement selon les directions X et Y. On peut par exemple faire appel à un montage tel que décrit dans le brevet US10309823 de la déposante.

### 5. Procédé de fabrication

On décrit à présent un procédé de fabrication et d'assemblage du dispositif de mesure 10 décrit ci-avant, en référence à la figure 7.

Dans une première étape 110, une plaque plane est fournie, par exemple une plaque en verre, en métal, en matériau composite, en aluminium (type anodisé) ou en plastique. La plaque plane peut être formée par injection et découpée selon la forme et les dimensions désirées pour la plaque de mesure 16. La plaque plane est également profilée pour présenter le bord arrondi 26. Le bord arrondi 26 peut être réalisé lors de l'injection ou par taille du verre postérieure.

Dans une deuxième étape 120, une couche de matériau conducteur est déposée sur la face supérieure 22, le bord arrondi 26, et la face inférieure 24 pour former l'au moins une électrode 18. Le dépôt de matériau conducteur peut être réalisé par dépôt en phase vapeur (« *Physical Vapor Déposition »,* PVD en anglais), notamment par évaporation ou pulvérisation magnétron (par exemple du « *sputtering* »). La plaque de mesure 16 est alors positionnée dans un four à dépôt et du matériau conducteur est appliqué par un pulvérisateur. Par exemple, le matériau déposé peut être de l'ITO, du nickel, de l'acier ou un alliage de cuivre. Alternativement, une peinture conductrice ou un revêtement conducteur de type Tecticoat^{™} (commercialisé par Heraeus) peut être utilisée.

En l'espèce, la deuxième étape 120 comprend une sous-étape 121 de dépôt sur la face supérieure 22, et une sous-étape 122 de dépôt sur la face inférieure 24. Avantageusement, le bord arrondi 26 tel que décrit ci-avant permet de former l'au moins une électrode 18 uniquement à partir des sous-étapes 121 et 122. En effet, le bord arrondi 26 étant une surface convexe (plus précisément une surface sans zone aveugle lorsque vue du dessus et/ou du dessous), le dépôt sur la face supérieure 22 et la face inférieure 24 suffit pour recouvrir l'ensemble du bord arrondi 26 de matériau conducteur. Chacun des dépôts recouvre une portion du bord arrondi 26, et il n'existe pas de portions aveugle au dépôt du matériau conducteur. En pratique, il peut y avoir une légère superposition des deux couches, mais l'épaisseur cumulée des deux couches peut ne pas être plus importante que l'épaisseur d'une seule couche (du fait de l'emplacement du bord 26 par rapport au pulvérisateur). Le procédé de fabrication est alors plus simple, rapide et économique qu'un procédé requérant une application individuelle de chaque face et d'un ou plusieurs bords de la plaque. De plus, un tel procédé permet d'éviter de devoir adapter le four à dépôt en phase vapeur pour pouvoir accueillir la plaque 16 dans une position différente ou pour pouvoir pulvériser le matériau conducteur sur le bord 26.

La deuxième étape 120, de dépôt, peut ne comprendre que la sous-étape 121 et la sous-étape 122 (pas d'étape de dépôt spécifiquement pour le bord donc).

Dans un mode de réalisation, la sous-étape 121 de dépôt sur la face supérieure 22 est un dépôt de premier matériau conducteur tel que discuté précédemment, et la sous étape 122 de dépôt sur la face inférieure 24 est un dépôt d'un deuxième matériau conducteur, tel que discuté précédemment. L'utilisation de deux matériaux distincts permet d'utiliser un matériau transparent pour le revêtement de la face supérieure 22, visible pour l'utilisateur, et un matériau plus simple à appliquer et/ou moins coûteux pour la face inférieure 24, non visible.

On note que les sous-étapes 121 et 122 sont interchangeables. La sous-étape 121 de dépôt sur la face supérieure 22 peut être avant ou après la sous-étape 122 de dépôt sur la face inférieure 24.

Dans une troisième étape 130, le matériau conducteur excédentaire est supprimé de la face supérieure 22, la face inférieure 24 et le bord arrondi 26, de sorte à délimiter les électrodes 18 et améliorer l'esthétique de la plaque de mesure 16. La suppression du matériau conducteur excédentaire peut notamment être réalisée par gravure chimique.

Le reste du procédé concerne l'assemblage du dispositif de mesure 10. Les étapes décrites peuvent être réalisées de différentes façons. Un exemple non limitatif pour chacune des étapes est donné.

Dans une quatrième étape 140, la plaque de support 38 est fournie. La plaque de support 38 peut avoir été fabriquée par moulage d'un matériau plastique. Dès lors, une quatrième étape 140 correspond au montage de l'ensemble électronique 20 sur la plaque de support 38. Les composants de l'ensemble électronique 20 peuvent par exemple être reçus dans des logements de la plaque de support 38, ou encore vissés ou collés sur la plaque de support 38. Le montage de l'ensemble électronique 20 sur la plaque de support 38 facilite l'intégration de l'électronique du dispositif de mesure 10. Pour préparer la plaque de support 38, les connecteurs électriques 30 sont montés sur les cartes de circuits 29 (PCB) qui seront en regard des électrodes 18. Les cartes de circuits 29 peuvent être monté sur la plaque de support 38 avant ou après l'étape 150.

Dans une cinquième étape 150, la plaque de support 38 est solidarisée avec la plaque de mesure 16 pour former l'unité de mesure 12. La plaque de support 38 est par exemple collée sur la face inférieure 24 de la plaque de mesure 16. On remarque que la solidarisation de l'ensemble électronique 20 et de la plaque de mesure 16 ne comprend pas d'étapes de perçage, ni d'étape de soudure destiné à mettre en contact les électrodes 18 avec l'ensemble électronique 20. Le procédé de fabrication est dépourvu d'étapes délicates ayant un taux de rebut élevé.

Dans une sixième étape 160, le socle 14 est fourni. Le socle peut être formé par a usinage ou moulage d'un matériau plastique ou métallique. La pièce de montage 48 peut éventuellement être insérée dans le socle 14, et être fixée par collage ou vissage. La pièce de montage 48 peut par ailleurs être moulée à partir de matériau plastique.

La septième étape 170 consiste à assembler l'unité de mesure 12 avec le socle 14, de sorte à obtenir le dispositif de mesure 10. Par exemple, des protubérances prévues dans la plaque de montage 38 de l'unité de mesure 12 peuvent coopérer avec des logements prévus dans la pièce de montage 48.

## Revendications

1. Dispositif de mesure électronique (10) comprenant :
- une plaque de mesure (16), s'étendant le long d'un plan de mesure (xy) et comprenant :
• une face supérieure (22) configurée pour recevoir des pieds d'un utilisateur;
• une face inférieure (24), opposée à la face supérieure (22), et
• un bord arrondi (26) reliant la face supérieure (22) à la face inférieure (24), et
le dispositif de mesure étant **caractérisé en ce qu'**il comprend en outre :
- au moins une électrode (18) s'étendant sur la plaque de mesure (16), depuis la face supérieure (22) jusqu'à la face inférieure (24) en passant sur le bord arrondi (26).

2. Dispositif de mesure selon la revendication 1, dans lequel le bord arrondi (26) est une surface convexe.

3. Dispositif de mesure selon l'une quelconque des revendications 1 à 2, dans lequel le bord arrondi (26) est tangent à la face supérieure (22) et à la face inférieure (24).

4. Dispositif de mesure selon l'une quelconque des revendications 1 à 3, dans lequel le bord arrondi (26) a une section en arc de cercle.

5. Dispositif de mesure selon l'une quelconque des revendications précédentes, comprenant une pluralité d'électrodes (18), dans lequel chaque électrode (18) forme une bande s'étendant de la face supérieure (22) à la face inférieure (24) en passant par le bord arrondi (26), et les bandes sont par exemple parallèles entre elles.

6. Dispositif de mesure (10) selon l'une quelconque des revendications précédentes, dans lequel l'au moins une électrode (18) est formée par un revêtement sur la plaque de mesure (16).

7. Dispositif de mesure (10) selon l'une quelconque des revendications précédentes, dans lequel l'au moins une électrode (18) s'étend sur la face inférieure (24) sur au moins 10cm.

8. Dispositif de mesure (10) selon l'une quelconque des revendications précédentes, comprenant en outre au moins un circuit imprimé (28) disposé en regard de la face inférieure (24) de la plaque de mesure (16), l'au moins un circuit imprimé (28) comprenant au moins un connecteur électrique (30) s'étendant vers la face inférieure (24) pour venir au contact de l'au moins une électrode (18), par exemple le circuit imprimé étant unique et étant relié à toutes les électrodes par des connecteurs électriques.

9. Dispositif de mesure (10) selon l'une quelconque des revendications précédentes, comprenant en outre un socle (14), dans lequel la plaque de mesure (16) est en retrait par rapport au socle (14), au moins au niveau du bord arrondi (26) sur lequel s'étend l'au moins une électrode (18).

10. Dispositif de mesure selon la revendication 9, dans lequel le retrait comprend un écart (G1, G2) entre la plaque de mesure (16) et le socle (14) qui est compris entre 0,4mm et 2cm, voire entre 0,4mm et 1cm, voire entre 0,4mm et 2mm.

11. Procédé de fabrication d'un dispositif de mesure (10) selon une des revendications précédentes, comprenant les étapes de :
- fourniture d'une plaque, dite plaque de mesure (16), comprenant :
• une face supérieure (22), configurée pour recevoir des pieds d'un utilisateur;
• une face inférieure (24), opposée à la face supérieure (22), et
• un bord arrondi (26) reliant la face supérieure (22) à la face inférieure (24) ;
- dépôt d'une couche d'au moins un matériau conducteur sur la face supérieure (22), le bord arrondi (26) et la face inférieure (24) pour former au moins une électrode (18).

12. Procédé de fabrication selon la revendication 11, dans lequel l'étape de dépôt comprend :
- un premier dépôt de matériau conducteur sur la face supérieure (22) et une première portion du bord arrondi (26) ;
- un deuxième dépôt de matériau conducteur sur la face inférieure (24) et une deuxième portion du bord arrondi (26), de sorte qu'il y ait une continuité de matériau conducteur entre la première portion du bord arrondi (26) et la deuxième portion du bord arrondi (26).

13. Procédé de fabrication selon la revendication 11 ou 12, comprenant en outre une étape de suppression de matériau conducteur excédentaire de la face supérieure (22), le bord arrondi (26) et la face inférieure (24).

14. Procédé de fabrication selon l'une quelconque des revendications 11 à 13, en combinaison avec la revendication 12, dans lequel l'étape de dépôt est composée uniquement du premier dépôt et du deuxième dépôt.

15. Procédé de fabrication selon l'une quelconque des revendications 11 à 14, dans lequel l'étape de dépôt est un dépôt en phase vapeur, par évaporation ou pulvérisation magnétron.

## Patentansprüche

1. An Elektronische Messvorrichtung (10), umfassend:
- eine Messplatte (16), die sich entlang einer Messebene (xy) erstreckt und umfasst:
• eine Oberseite (22), die zur Aufnahme der Füße eines Benutzers ausgebildet ist;
• eine untere Fläche (24) gegenüber der oberen Fläche (22), und
• einen abgerundeten Rand (26), der die obere Fläche (22) mit der unteren Fläche (24) verbindet, und
die Messvorrichtung **dadurch gekennzeichnet ist, dass** sie außerdem umfasst:
- mindestens eine Elektrode (18), die sich auf der Messplatte (16) von der Oberseite (22) über den abgerundeten Rand (26) zur Unterseite (24) erstreckt.

2. Messvorrichtung nach Anspruch 1, wobei die abgerundete Kante (26) eine konvexe Fläche ist.

3. Messvorrichtung nach einem der Ansprüche 1 bis 2, wobei die abgerundete Kante (26) die obere Fläche (22) und die untere Fläche (24) tangiert.

4. Messvorrichtung nach einem der Ansprüche 1 bis 3, wobei die abgerundete Kante (26) einen kreisbogenförmigen Querschnitt aufweist.

5. Messvorrichtung nach einem der vorhergehenden Ansprüche, mit mehreren Elektroden (18), wobei jede Elektrode (18) einen Streifen bildet, der sich von der Oberseite (22) über die abgerundete Kante (26) zur Unterseite (24) erstreckt, und die Streifen beispielsweise parallel zueinander sind.

6. Messvorrichtung (10) nach einem der vorhergehenden Ansprüche, wobei die mindestens eine Elektrode (18) durch eine Beschichtung auf der Messplatte (16) gebildet ist.

7. Messvorrichtung (10) nach einem der vorhergehenden Ansprüche, wobei die mindestens eine Elektrode (18) die Unterseite (24) um mindestens 10 cm überragt.

8. Messvorrichtung (10) nach einem der vorhergehenden Ansprüche, die ferner mindestens eine gedruckte Schaltung (28) umfasst, die gegenüber der Unterseite (24) der Messplatte (16) angeordnet ist, wobei die mindestens eine gedruckte Schaltung (28) mindestens einen elektrischen Anschluss (30) umfasst, der sich in Richtung der Unterseite (24) erstreckt, um die mindestens eine Elektrode (18) zu kontaktieren, wobei die gedruckte Schaltung beispielsweise einzigartig ist und mit allen Elektroden durch elektrische Anschlüsse verbunden ist.

9. Messvorrichtung (10) nach einem der vorhergehenden Ansprüche, die ferner eine Basis (14) umfasst, wobei die Messplatte (16) zumindest an der abgerundeten Kante (26), über die sich die mindestens eine Elektrode (18) erstreckt, von der Basis (14) zurückgesetzt ist.

10. Messvorrichtung nach Anspruch 9, wobei die Aussparung einen Spalt (G1, G2) zwischen der Messplatte (16) und der Basis (14) umfasst, der zwischen 0,4 mm und 2 cm oder zwischen 0,4 mm und 1 cm oder zwischen 0,4 mm und 2 mm liegt.

11. Verfahren zur Herstellung einer Messvorrichtung (10) nach einem der vorhergehenden Ansprüche, das die folgenden Schritte umfasst:
- Bereitstellen einer Platte, Messplatte (16) genannt, mit:
• eine Oberseite (22), die zur Aufnahme der Füße eines Benutzers ausgebildet ist;
• eine untere Fläche (24) gegenüber der oberen Fläche (22), und
• eine abgerundete Kante (26), die die obere Fläche (22) mit der unteren Fläche (24) verbindet;
- Aufbringen einer Schicht aus mindestens einem leitfähigen Material auf die obere Fläche (22), den abgerundeten Rand (26) und die untere Fläche (24), um mindestens eine Elektrode (18) zu bilden.

12. Herstellungsverfahren nach Anspruch 11, wobei der Abscheidungsschritt umfasst:
- eine erste Abscheidung von leitfähigem Material auf der oberen Fläche (22) und einem ersten Teil der abgerundeten Kante (26);
- eine zweite Ablagerung von leitfähigem Material auf der unteren Fläche (24) und einem zweiten Abschnitt der abgerundeten Kante (26), so dass eine Kontinuität von leitfähigem Material zwischen dem ersten Abschnitt der abgerundeten Kante (26) und dem zweiten Abschnitt der abgerundeten Kante (26) besteht.

13. Das Herstellungsverfahren nach Anspruch 11 oder 12 umfasst ferner einen Schritt des Entfernens von überschüssigem leitfähigem Material von der oberen Fläche (22), dem abgerundeten Rand (26) und der unteren Fläche (24).

14. Herstellungsverfahren nach einem der Ansprüche 11 bis 13, in Kombination mit Anspruch 12, wobei der Abscheidungsschritt nur aus der ersten Abscheidung und der zweiten Abscheidung besteht.

15. Herstellungsverfahren nach einem der Ansprüche 11 bis 14, bei dem der Abscheidungsschritt durch Aufdampfen oder Magnetronsputtern erfolgt.

## Claims

1. An electronic measuring device (10) comprising:
- a measuring plate (16), extending along a measuring plane (xy) and comprising:
• an upper face (22) configured to receive a user's feet;
• a lower face (24) opposite the upper face (22), and
• a rounded edge (26) connecting the upper face (22) to the lower face (24), and the measuring device being **characterized in that** it further comprises:
- at least one electrode (18) extending on the measuring plate (16), from the upper face (22) over the rounded edge (26) to the lower face (24).

2. The measuring device according to claim 1, wherein the rounded edge (26) is a convex surface.

3. The measuring device according to any one of claims 1 to 2, wherein the rounded edge (26) is tangent to the upper face (22) and the lower face (24).

4. The measuring device according to any one of claims 1 to 3, wherein the rounded edge (26) has a circular arc cross-section.

5. The measuring device according to any of the preceding claims, comprising a plurality of electrodes (18), wherein each electrode (18) forms a strip extending from the upper face (22) to the lower face (24) via the rounded edge (26), and the strips are for example parallel to each other.

6. The measuring device (10) according to any of the preceding claims, wherein the at least one electrode (18) is formed by a coating on the measuring plate (16).

7. The measuring device (10) according to any of the preceding claims, wherein the at least one electrode (18) extends over the lower face (24) by at least 10cm.

8. The measuring device (10) according to any one of the preceding claims, further comprising at least one printed circuit (28) arranged opposite the lower face (24) of the measuring plate (16), the at least one printed circuit (28) comprising at least one electrical connector (30) extending towards the lower face (24) to contact the at least one electrode (18), for example the printed circuit board being unique and being connected to all the electrodes by electrical connectors.

9. The measuring device (10) according to any of the preceding claims, further comprising a base (14), wherein the measuring plate (16) is recessed from the base (14), at least at the rounded edge (26) over which the at least one electrode (18) extends.

10. The measuring device according to claim 9, wherein the recess comprises a gap (G1, G2) between the measuring plate (16) and the base (14) which is comprised between 0.4mm and 2cm, or between 0.4mm and 1cm, or between 0.4mm and 2mm.

11. A process of manufacturing a measuring device (10) according to any of the preceding claims, comprising the steps of:
- providing a plate, called a measuring plate (16), comprising:
• an upper face (22), configured to receive a user's feet;
• a lower face (24) opposite the upper face (22), and
• a rounded edge (26) connecting the upper face (22) to the lower face (24);
- depositing a layer of at least one conductive material on the upper face (22), the rounded edge (26) and the lower face (24) to form at least one electrode (18).

12. The manufacturing process according to claim 11, wherein the deposition step comprises :
- a first deposition of conductive material on the upper face (22) and a first portion of the rounded edge (26);
- a second deposition of conductive material on the lower face (24) and a second portion of the rounded edge (26), so that there is continuity of conductive material between the first portion of the rounded edge (26) and the second portion of the rounded edge (26).

13. The manufacturing process according to claim 11 or 12, further comprising a step of removing excess conductive material from the upper face (22), the rounded edge (26) and the lower face (24).

14. The manufacturing process according to any one of claims 11 to 13, in combination with claim 12, wherein the deposition step is composed solely of the first deposition and the second deposition.

15. The manufacturing process according to any one of claims 11 to 14, wherein the deposition step is vapor deposition, by evaporation or magnetron sputtering.
